(19) Europäisches Patentamt
European Patent Office
Office européen des brevets

(11) **EP 1 141 781 B1**

(12) **EUROPÄISCHE PATENTSCHRIFT**

(45) Veröffentlichungstag und Bekanntmachung des Hinweises auf die Patenterteilung:
**08.02.2006 Patentblatt 2006/06**

(51) Int Cl.:
*G03F 7/20* (2006.01)          *G02B 13/14* (2006.01)
*G02B 13/18* (2006.01)          *G02B 13/22* (2006.01)

(21) Anmeldenummer: **99961020.7**

(22) Anmeldetag: **27.11.1999**

(86) Internationale Anmeldenummer:
**PCT/EP1999/009235**

(87) Internationale Veröffentlichungsnummer:
**WO 2000/033138 (08.06.2000 Gazette 2000/23)**

(54) **HOCHAPERTURIGES PROJEKTIONSOBJEKTIV MIT MINIMALEM BLENDENFEHLER**

LARGE-APERTURED PROJECTION LENS WITH MINIMAL DIAPHRAGM ERROR

OBJECTIF A PROJECTION A GRANDE OUVERTURE AVEC DES ERREURS D'OUVERTURE FORTEMENT REDUITES

(84) Benannte Vertragsstaaten:
**DE FR GB NL**

(30) Priorität: **30.11.1998 DE 19855108**
**30.11.1998 DE 19855157**
**14.05.1999 DE 19922209**
**04.09.1999 DE 19942281**

(43) Veröffentlichungstag der Anmeldung:
**10.10.2001 Patentblatt 2001/41**

(73) Patentinhaber: **Carl Zeiss SMT AG**
**73447 Oberkochen (DE)**

(72) Erfinder:
• **SCHUSTER, Karl-Heinz**
**D-89551 Königsbronn (DE)**
• **ULRICH, Wilhelm**
**D-73434 Aalen (DE)**

(74) Vertreter: **Müller-Rissmann, Werner Albrecht et al**
**Carl Zeiss,**
**Patentabteilung**
**73446 Oberkochen (DE)**

(56) Entgegenhaltungen:
**EP-A- 0 783 137          EP-A- 0 803 755**
**EP-A- 0 828 171          DE-A- 19 653 983**
**DE-A- 19 743 236          DE-A- 19 818 444**
**US-A- 5 448 408          US-A- 5 469 299**
**US-A- 5 805 344**

• **BRUNING J H: "Optical Lithography - Thirty years and three orders of magnitude" PROC. SPIE - INT. SOC. OPT. ENG., Bd. 3049, 1997, Seiten 14-27, XP000882444 USA in der Anmeldung erwähnt**

**Beschreibung**

Die Erfindung betrifft ein Projektionsobjektiv der Mikrolithographie, bei dem die Systemblende im Bereich des bildseitg letzten Bauches angeordnet ist, das eine bildseitige numerische Apertur NA von über 0,65 aufweist und einen Bildfelddurchmesser von über 20mm. Derartige Objektive zeichnen sich typischerweise durch eine Auflösung von unter 0.5 Mikrometern bei geringster Verzeichnung und zumindest bildseitige Telezentrie aus.

Das gattungsgemäße mikrolithographische Reduktionsobjektiv nach dem Oberbegriff des Anspruchs 1 ist ein rein refraktives Hochleistungsobjektiv, wie es für die hochauflösende Mikrolithographie besonders im DUV-Wellenlängenbereich benötigt wird.

Derartige refraktive Objektive mit zwei Strahltaillen sind schon in dem Artikel von E. Glatzel "New ienses for microlithography" SPIE. Vol. 237, 310 (1980) beschrieben und seitdem ständig weiterentwickelt worden. Gattungsgemäße Objektive der Firma Carl Zeiss werden in Wafer-Steppern und Wafer-Scannern PAS der Firma ASML. Niederlande, verkauft.

Ein derartiges Objektiv der Firma Tropel aus dem Jahre 1991 ist in Figur 16 von J.H. Bruning "Optical Lithography - Thirty years and three orders of magnitude" SPIE, Vol 3049, 14-27 (1997) gezeigt. Zahlreiche Varianten gattungsgemäßer Projektionsobjektive finden sich in Patentanmeldungen, so EP 0 712 019-A (US Ser. 337 647 v. 10. Nov. 1994). EP 0 717 299-A. EP 0 721 150-A. EP 0 732 605-A. EP 0 770 895-A. EP 0 803 755-A (US 5.781.278). EP 0 828 172-A

Ähnliche Objektive mit noch etwas kleinerer numerischer Apertur finden sich auch in SU 1 659 955-A. EP 0 742 492-A (Fig. 3) US 5,105.075 (Fig. 2 und 4). US 5,260.832 (Fig. 9) und DD 299 017-A.

Die Blende liegt bei den zitierten Schriften allerdings vielfach anders, insbesondere im Bereich der zweiten Taille.

Regelmäßig ist bei den hochaperturigen Mikrolithographie-Projektionsobjektiven die Möglichkeit des Abblendens auf ca. 60 bis 80 % der maximalen bildseitigen numerischen Apertur vorgesehen.

In der erst nach den Prioritätstagen dieser Anmeldung veröffentlichten DE 199 02 336 A1 wird diese Abblendbarkeit explizit angegeben. In dieser wie auch in der DE 198 18 444 A1 wird auch die Verwendung asphäfischer Linsen vorgesehen, und zwar stets mindestens einer Asphäre im. Bereich der zweiten Taille (vierte Linsengruppe).

Die Beispiele Fig 1-3 der Prioritätsanmeldung DE 198 55 108 8 zeigen eine relativ stark gekrümmte Pupillenebene mit ca. 25 mm axialem Versatz zwischen optischer Achse und Rand des Lichtbündels bei voller Öffnung. Dementsprechend sind zum Abblenden aufwändige Blendenkonstruktionen erforderlich.

Als Pupillenebene wird im Sinne dieser Patentanmeldung die gekrümmte Fläche der Pupille oder Fouriertransformierten der Bildebene verstanden, wie sie durch Abbildungsfehler der Linsenanordnung real ausgebildet ist. Der Rand der Aperturblende des Systems muß auf dieser Fläche liegen, wenn Vignettierungseffekte unterbunden sein sollen. Wird die reale Aperturblende in einer planen geometrischen Ebene enger und weiter gemacht, so gilt die Vignettierungsfreiheit näherungsweise umso besser, je weniger die Pupillenebene von einer Planfläche abweicht.

Aufgabe der Erfindung ist die Bereitsstellung gattungsgemäßer Objektive mit gut korrigierter Pupille, was ein sauberes Abblenden ohne Störeffekte mit einfachen Blendenkonstruktionen erlaubt.

Gelöst wird diese Aufgabe durch ein gartungsgemäßes Projektionsobjektiv mit den kennzeichnenden Merkmalen eines der Ansprüche 1 bis 2- oder von Kombinationen davon.

Die Pupillenebene ist gemäß Anspruch 1 nur noch um höchstens 20 mm, vorzugsweise aber um weniger als 15 mm durchgebogen.

Die bildseitige Telezentrie wird gemäß Anspruch 2 auch bei Abblendung auf das 0,8 fache der nominellen (maximalen) bildseitigen numerischen Apertur sehr gut stabil gehalten, gemessen am geometrischen Schwerstrahl liegt sie unter $\pm 4$ mrad.

Da die Bildfeldwölbung des vorderen bzw hinteren Objektivteils alleine nicht exakt korrigiert werden kann (jedenfalls nicht mit vertretbarem Aufwand, da das nur über die Brechkraftverteilung zu beeinflussen ist) wird der Bildfehlerkompromiss in der Blendenebene so gewählt, dass die Bildfeldwölbung zumindest in der für die Blendenkonstruktion relevanten tangentialen Abbildung teilweise durch Astigmatismus (der über gezielte Linsendurchbiegung bei unveränderter Brechkraft eingestellt werden kann) kompensiert wird.

Aus der Sicht der optischen Korrektion des Objektivs ist gemäß Anspruch 3 die tangentiale Bildschale der Pupillenabbildung im Blendenraum auf unter 20 mm korrigiert. Es wird also im Bildfehlerkompromiss des Objektivs auch explizit die Ausbildung der Pupillenebene berücksichtigt.

Im Raum hinter der Pupillenebene wird bei gattungsgemäßen Projektionsobjektiven zur Korrektur der sphärischen Aberration eine Negativlinse benötigt.

Gemäß Anspruch 4 wird nun die erfindungsgemäße Pupillenkorrektur bei Vorhandensein eines pupillenseitig konkaven Meniskus erreicht, was eine gute Korrektur aller Abbildungsfehler erlaubt. Je flacher der zerstreuende bildseitige Radius der Negativlinse, desto günstiger ist dies für die Pupillenkorrektur.

Anspruch 5 zeigt die bevorzugte Blendenlage klar weg von der zweiten Taille und gibt auch einen wesentlichen Unterschied zur DE 199 02 336 A1 und zu anderen Schriften aus dem Stand der Technik.

Die Strahlumlenkung in diesem Bereich des dritten Bauchs mit vielen schwachen Positivlinsen ergibt minimierte sphärische Unterkorrektur und erlaubt so schwache Negativlinsen, was wiederum die Korrektur der Pupillenebene entspannt. Insgesamt wird die Variation der Bildfehler beim Abblenden oder bei verschiedenen Beleuchtungssettings durch diese Maßnahme verringert.

Der laut Anspruch 5 vorteilhafterweise vorgesehene sphärisch überkorrigierende Luftraum, dessen Mittendicke größer als die Randdicke ist, läßt sich vorteilhaft in der Nachbarschaft des negativen Meniskus nach Anspruch 3 anordnen.

Anspruch 6 gibt die Erkenntnis wieder, daß eine asphärische Linse mit Vorteil im Bereich vor der ersten Taille angeordnet wird. Asphären im Bereich der zweiten Taille werden dann gemäß Anspruch 7 entbehrlich, während sie im Stand der Technik nach DE 199 02 336 A1 und DE 198 18 444 A1 gerade dort bevorzugt anzuordnen sind.

Anspruch 8 sieht die Materialwahl der Linsen aus Quarzglas und/oder Fluoridkristallen vor, womit die Objektive für den DUV/VUV Bereich, insbesondere bei den Wellenlängen 248 mm, 193 mm und 157 mm geeignet werden. Bevorzugte Fluoridkristalle sind CaF2, BaF2, SrF2, NaF und LiF. Näheres hierzu findet sich in der DE 199 08 544.

Anspruch 4 sieht es als vorteilhaft vor, daß das erfindungsgemäße Projektionsobjektiv wie in den Ausführungsbeispielen zwei Taillen und drei Bäuche aufweist. Dies erlaubt eine sehr gute Petzval-Korrektur bei anspruchsvollen Werten von Apertur und Feld.

Die Ansprüche 9 und 10 betreffen eine Projektionsbelichtungsanlage mit einem erfindungsgemäßen Objektiv und ein mikrolithographisches Herstellverfahren damit.

Anspruch 11 gibt besonders die erfindungsgemäß optimierte Möglichkeit der Anwendung von Belichtungen mit verschiedenen Beleuchtungsarten und / oder numerischer Apertur wieder.

Näher erläutert wird die Erfindung anhand der Ausführungsbeispiele gemäß der Zeichnung und der Tabellen.

Figur 1          zeigt qualitativ eine Projektionsbelichtungsanlage gemäß der Erfindung.

Figur 2          zeigt den Linsenschnitt eines 193 mm Quarzglas/CaF2-Projektionsobjektivs mit NA = 0,70.

Figur 3          zeigt den Linsenschnitt durch eine zweite Linsenanordnung, die zwei asphärische Linsenoberflächen aufweist;

Figur 4          zeigt den Linsenschnitt durch eine dritte Linsenanordnung, die drei asphärische Oberflächen aufweist;

Figur 5a bis 5g    zeigen die Darstellung der tangentialen Queraberrationen;

Figur 6a bis 6g    zeigen die Darstellung der sagittalen Queraberrationen;

Figur 7a bis 7f    zeigen die Darstellung des Rinnenfehlers anhand von Schnitten;

Figur 8          zeigt den Linsenschnitt durch eine vierte Linsenanordnung für 248 nm mit NA = 0,70.

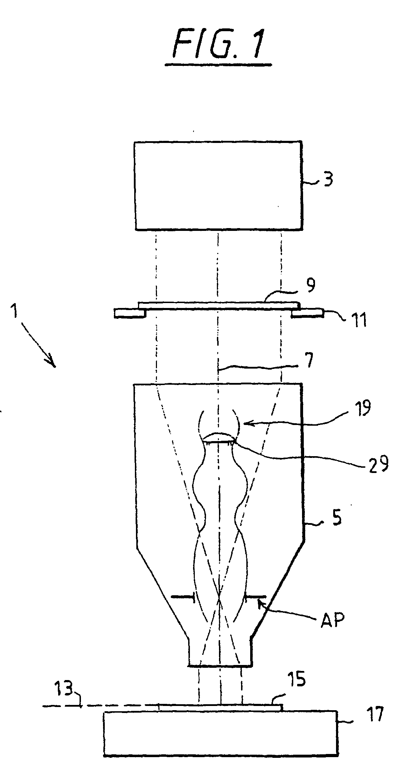

Anhand von Figur 1 wird zunächst der prinzipielle Aufbau einer Projektionsbelichtungsanlage beschrieben. Die Projektionsbelichtungsanlage 1 weist eine Beleuchtungseinrichtung 3 und ein Projektionsobjektiv 5 auf. Das Projektionsobjektiv umfaßt eine Linsenanordnung 19 mit einer Aperturblende AP. wobei durch die Linsenanordnung 19 eine optische Achse 7 definiert wird. Zwischen Beleuchtungseinrichtung 3 und Projektionsobjektiv 5 ist eine Maske 9 angeordnet, die mittels eines Maskenhalters 11 im Strahlengang gehalten wird. Solche in der Mikrolithographie verwendeten Masken 9 weisen eine Mikrostruktur auf, die mittels des Projektionsobjektives 5 verkleinert auf eine Bildebene 13 abgebildet wird. In der Bildebene 13 wird ein durch einen Substrathalter 17 positioniertes Substrat bzw. ein Wafer 15 gehalten.

Im folgenden werden diese für gehobene Ansprüche an die Bildqualität sowie an die Auflösung ausgelegten Projektionsobjektive 5, insbesondere deren Linsenanordnung 19, näher beschrieben.

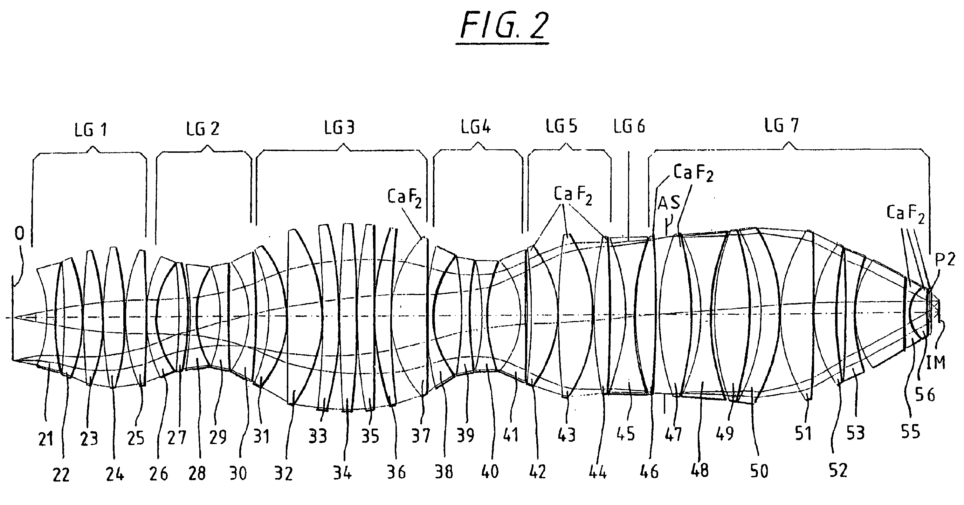

Das Ausführungsbeispiel nach Fig. 2 und Tabelle 1 ist ein Projektionsobjektiv mit rein sphärischen Linsen, als Quarzglas/CaF2 Teilachromat für 193 μm Excimer-Laser mit 0,5 pm Bandbreite. Die bildseitige NA ist 0,70, der Bildfelddurchmesser beträgt 29,1 mm. Die Pupillenebene mit der Aperturblende AS liegt weit abgerückt von der zweiten Taille im Bereich einer Zwischeneinschnürung des dritten Bauchs. Ihre Durchbiegung beträgt 15.8 mm bei einem Lichtbündeldurchmesser von 212 mm.

Zur Bestimmung der Durchbiegung der Pupillenebene wird die tangentiale Bildschale der Pupillenabbildung im Blendenraum bestimmt, derart, dass die axiale Ablage des durch den Objektivteil zwischen Bildebene und Pupillenebene erzeugten Bilds eines unter dem Aperturwinkel durch das Bildfeld tretenden Parallelstrahls gegenüber dem Bild eines achsparallelen Parallelstrahls bestimmt wird. Der für Abblendung und Vignettierung nicht erhebliche sagittale Wert beträgt hier 26,5 mm und zeigt so den eingeführten Astigmatismus.

Bei Abblendung auf NA=0,56 zeigt das Objektiv eine Telezentrieabweichung des geometrischen Schwerstrahls von 3 mrad.

Besonderer Wert wurde bei dieser Linsenanordung auch auf kleine Durchmesser der CaF2-Linsen gelegt, da deren Verfügbarkeit eingeschränkt ist.

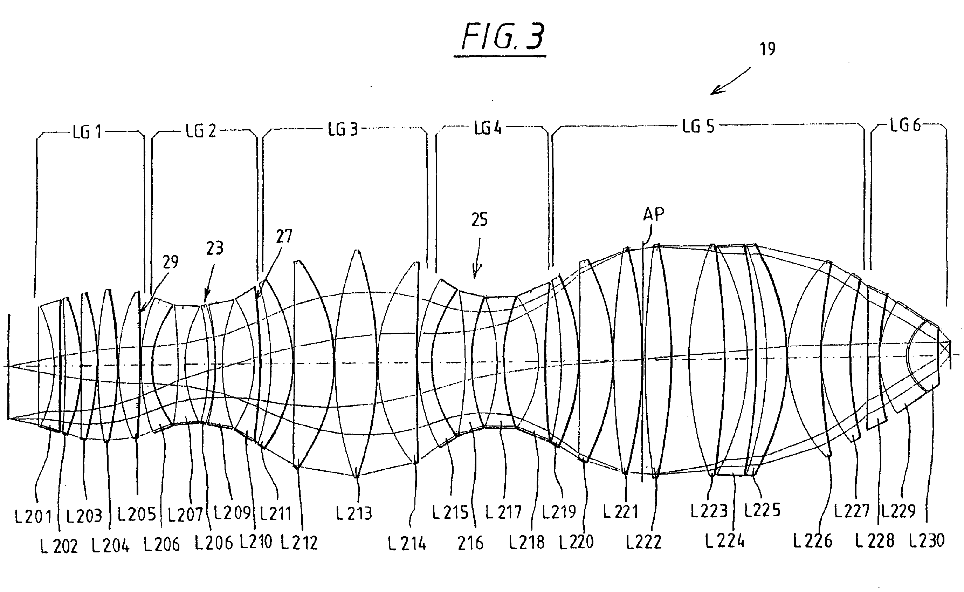

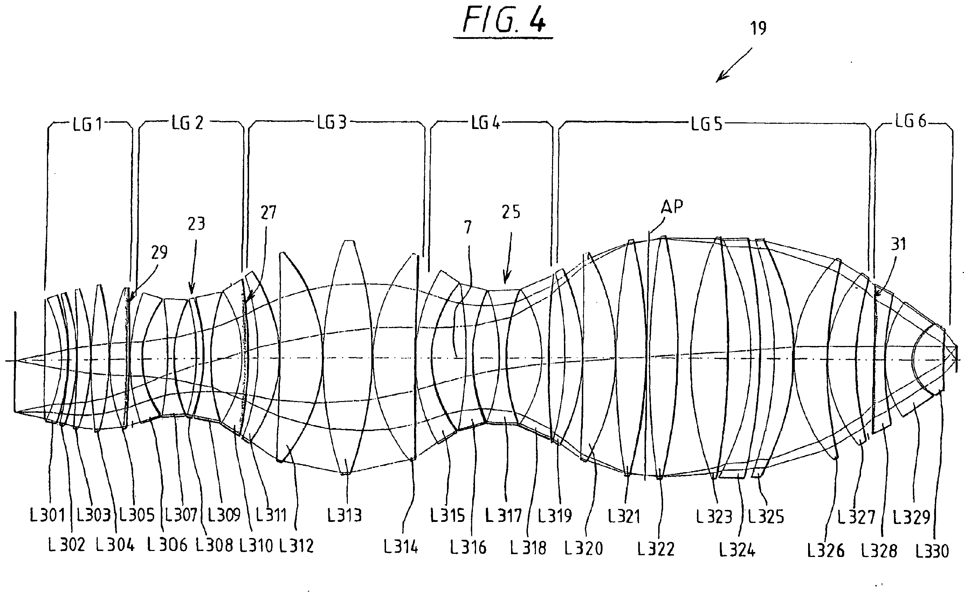

Die Beispiele der Fig 3 und 4 weisen Asphären auf. Diese asphärischen Flächen werden durch die Gleichung:

$$P(h) = \frac{\delta * h^2}{1 + \sqrt{1-(1-EX) * \delta^2 * h^2}} + C1\, h^4 + \ldots + C_n\, h^{2n-2} \quad \text{mit} \quad \delta = 1/R$$

beschrieben, wobei P die Pfeilhöhe als Funktion des Radius h (Höhe zur optischen Achse 7) mit den in den Tabellen angegebenen asphärischen Konstanten $C_1$ bis $C_{11}$ ist. R ist der in den Tabellen angegebene Scheitelradius.

In Figur 3 und Tab. 2 ist eine für die Wellenlänge $\lambda$ = 248 nm ausgelegte Quarzglas-Linsenanordnung 19 im Schnitt gezeigt. Diese Linsenanordnung 19 mit NA=0,75 und Bildfelddurchmesser 27,2 mm weist zwei asphärische Linsenflächen 27,29 auf. Die erste asphärische Linsenfläche 27 ist auf der Linse L210 bildseitig angeordnet. Es könnte auch vorgesehen sein, diese zweite asphärische Linsenoberfläche 27 auf der der Beleuchtungseinrichtung zugewandten Seite der Linse L211 anzuordnen. Die beiden Linsen L210 und L211 sind für die Aufnahme der asphärischen Linsenoberfläche 27 prädestiniert. Es kann auch vorgesehen sein, anstelle der Linsen L210 und L211 eine Meniskenlinse vorzusehen, die eine asphärische Linsenoberfläche aufweist. Die zweite asphärische Linsenoberfläche 29 ist im Endbereich der ersten Linsengruppe, auf der der Beleuchtungseinrichtung 3 abgewandten Seite der Linse L205, angeordnet. Es kann auch vorgesehen sein, diese asphärische Linsenoberfläche 29 auf der darauf folgenden Linse L206 in dem Beginn der zweiten Linsengruppe anzuordnen.

Eine besonders große Wirkung erhält man bei der Anordnung der Asphären 27, 29 auf Linsenoberflächen, bei denen die auftreffenden Strahlen zur jeweiligen Oberflächennormalen einen großen Winkel einschließen. Dabei ist besonders die große Variation der Auftreffwinkel bedeutsam. Infolgedessen haben in diesem Ausführungsbeispiel die einander zugewandten Linsenoberflächen der Linsen L210, L211 einen größeren Einfluß auf den Strahlenverlauf im Vergleich zu der jeweils anderen Linsenoberfläche der entsprechenden Linse L210, L211.

Im Bereich der zweiten Taille, Linsengruppe LG4, ist keine Asphäre vorgesehen.

Bei einer Länge von 1000 mm und einem maximalen Linsendurchmesser von 237,3 mm weist diese Linsenanordnung bei einer Wellenlänge von 248,38 nm eine numerische Apertur von 0,75 auf. Die Bildfelddiagonale beträgt 27,21 mm. Es ist eine Strukturbreite von 0,15 $\mu$m auflösbar. Die größte Abweichung von der idealen Wellenfront beträgt 13,0 m$\lambda$. Die genauen Linsendaten, bei denen diese Leistungsdaten erreicht werden, sind der Tabelle 2 zu entnehmen.

Die Pupillenebene schneidet die optische Achse bei AP. Ihre Durchbiegung beträgt 12,8 mm. Eine Abblendung auf NA=0,60 ist ohne Qualitätsverlust mit einer in der Ebene AP liegenden Blende möglich. Die Telezentrieabweichung des geometrischen Schwerstrahls beträgt dabei ca. 1.5 mrad.

Eine weitere Ausführungsform einer Linsenanordnung 19 für die Wellenlänge 248,38 nm ist in Figur 4 und Tabelle 3 gezeigt. Bei einer bildseitigen NA=0,77 ist der Bildfelddurchmesser 27,2mm.

Diese Linsenanordnung 19 weist drei Linsen L305, L310, L328 auf, die jeweils eine asphärische Linsenoberfläche 27, 29, 31 aufweisen. Die asphärischen Linsenoberflächen 27, 29 sind an den aus Figur 3 bekannten Positionen belassen worden. Durch die asphärische Linsenoberfläche 27 ist die Koma mittleren Ordnung für die Bildfeldzone einstellbar. Dabei sind die Rückwirkungen auf Schnitte in tangentialer Richtung sowie sagittaler Richtung gering.

Die zusätzliche dritte asphärische Linsenoberfläche 31 ist maskenseitig auf der Linse L328 angeordnet. Diese asphärische Linsenoberfläche 31 unterstützt die Komakorrektur zum Bildfeldrand hin.

Mittels dieser drei asphärischen Linsenoberflächen 27. 29. 31 wird bei einer Wellenlänge von 248.38 nm bei einer Länge von nur 1000 mm und einem maximalen Linsendurchmesser von 247,2 mm die weiter gesteigerte numerische Apertur von 0.77 und eine im gesamten Bildfeld gut auflösbare Strukturbreite von 0,14 $\mu$m erreicht. Die maximale Abweichung von der idealen Wellenfront beträgt 12.0 m$\lambda$.

Um die Durchmesser der Linsen in LG5 klein zu halten und um eine für das System vorteilhafte Petzvalsumme, die nahezu null sein sollte beizubehalten, sind die drei Linsen L312, L313, L314 in der dritten Linsengruppe LG3 vergrößert. Für die Bereitstellung des erforderlichen axialen Bauraumes für diese drei Linsen L312-L314 sind die Dicken anderer Linsen und damit die Durchmesser, insbesondere der Linsen der ersten Gruppe LG1, reduziert worden. Dies ist ein ausgezeichneter Weg, um in einem begrenzten Bauraum sehr große Bildfelder und Aperturen unterzubringen.

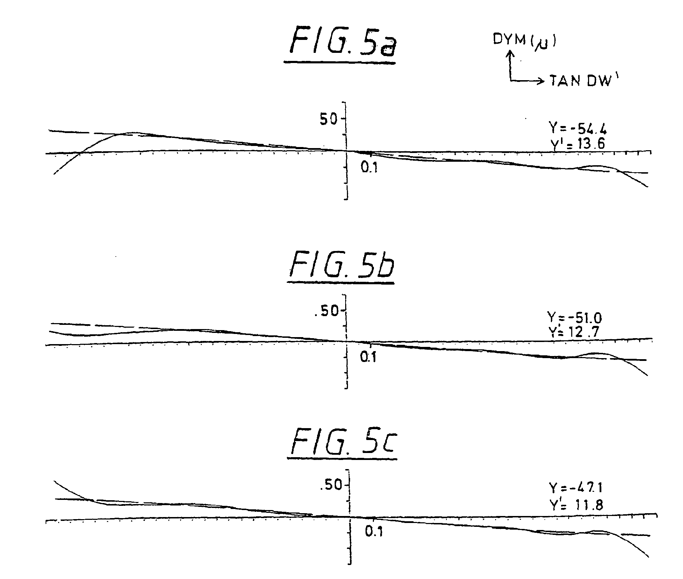

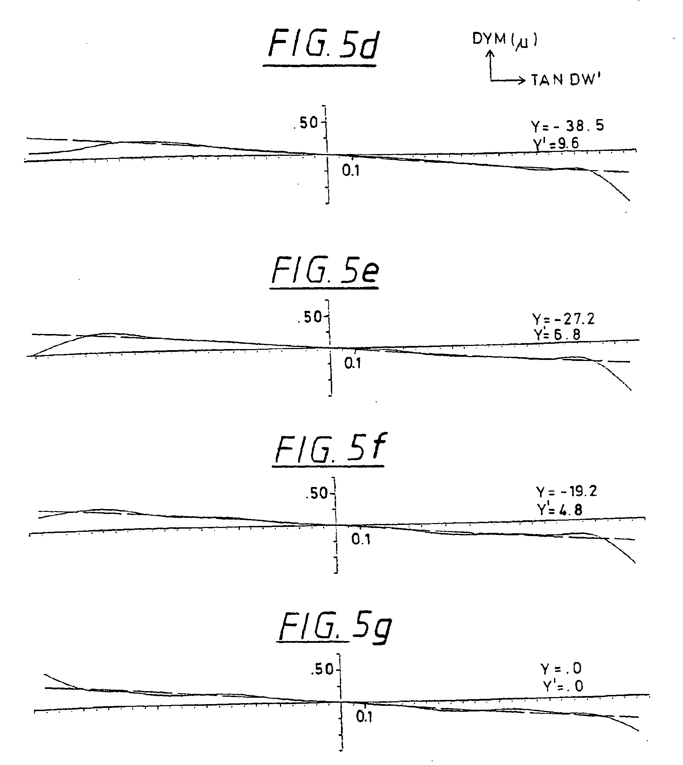

Die hohe Bildqualität, die durch diese Linsenanordnung erreicht wird, ist aus den Figuren 5a - 5g, Figur 6a - 6g und Figur 7a - 7f zu ersehen.

Figuren 5a - 5g geben für die Bildhöhen Y' (in mm) die meridionale Queraberration DYM an. Alle zeigen bis zu den höchsten DW' hervorragenden Verlauf.

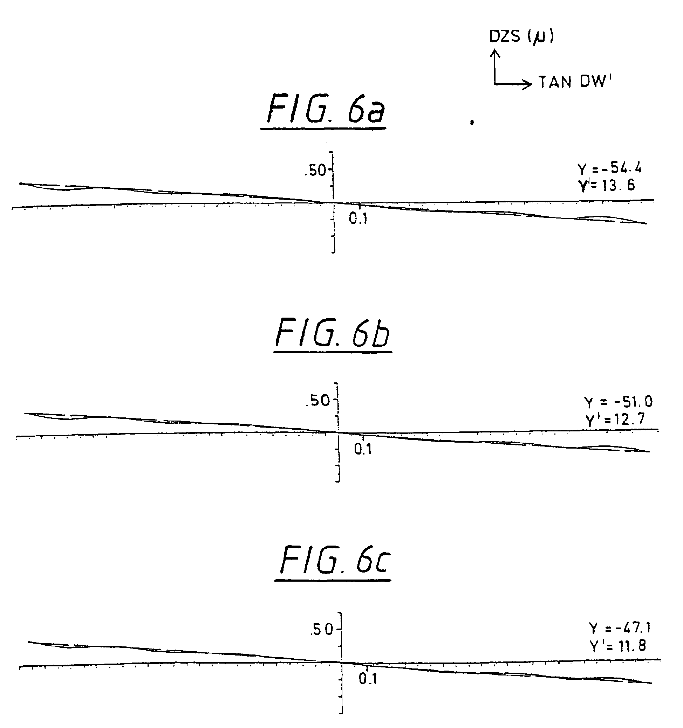

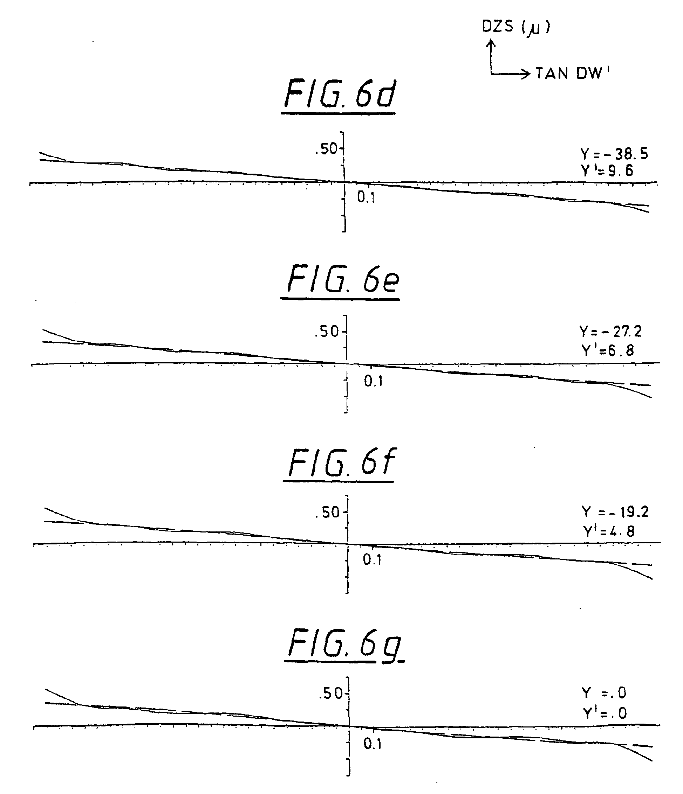

Figuren 6a - 6g geben für die gleichen Bildhöhen die sagittalen Queraberrationen DZS als Funktion des halben Aperturwinkels DW' an.

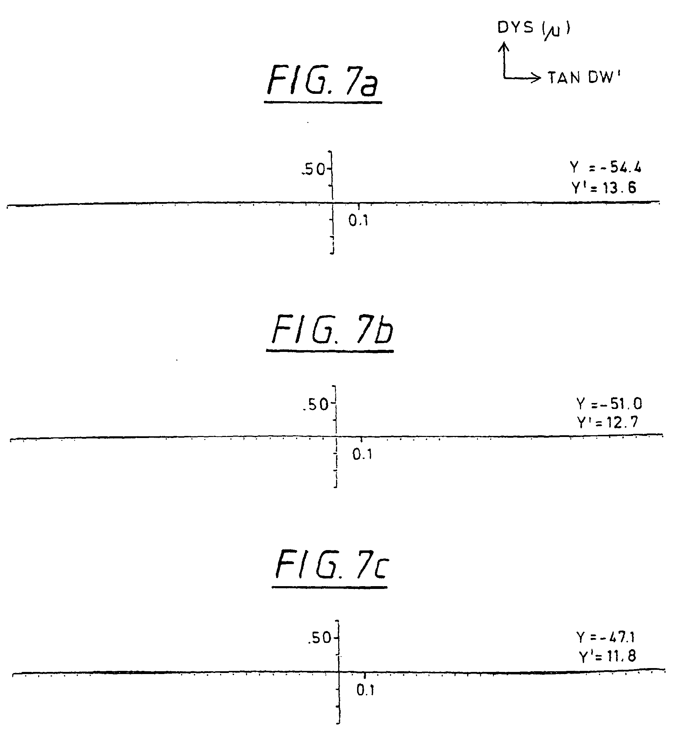

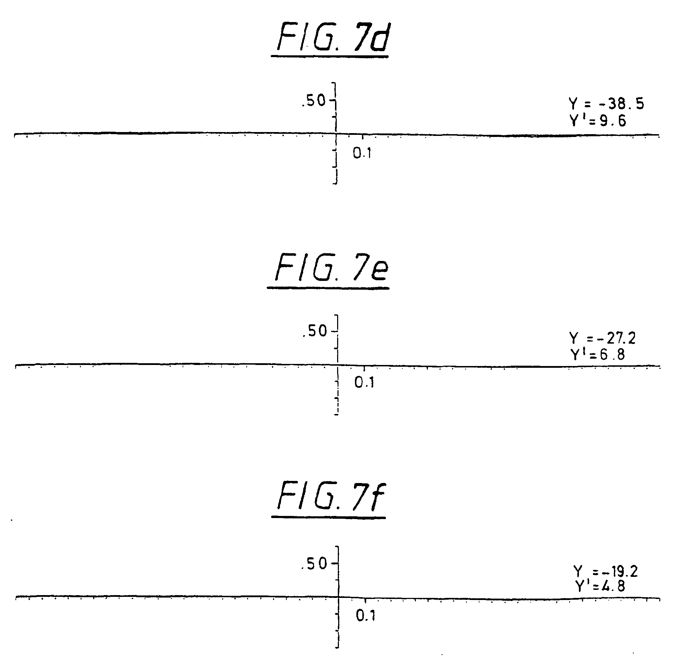

Figuren 7a - 7f geben für die gleichen Bildhöhenden den Rinnenfehler DYS an, der durchgängig nahezu null ist.

Die genauen Linsendaten sind der Tabelle 3 zu entnehmen, wobei die asphärischen Linsenoberflächen 27, 29, 31 an der gewährleistbaren hohen Bildqualität einen erheblichen Anteil haben.

Die Durchbiegung der Pupillenebene AP beträgt 14.6 mm bei voller Apertur. Die Telezentrieabweichung bei Abblendung auf NA = 0.62 beträgt 1,5 mrad, bestimmt wie bei den vorhergehenden Beispielen.

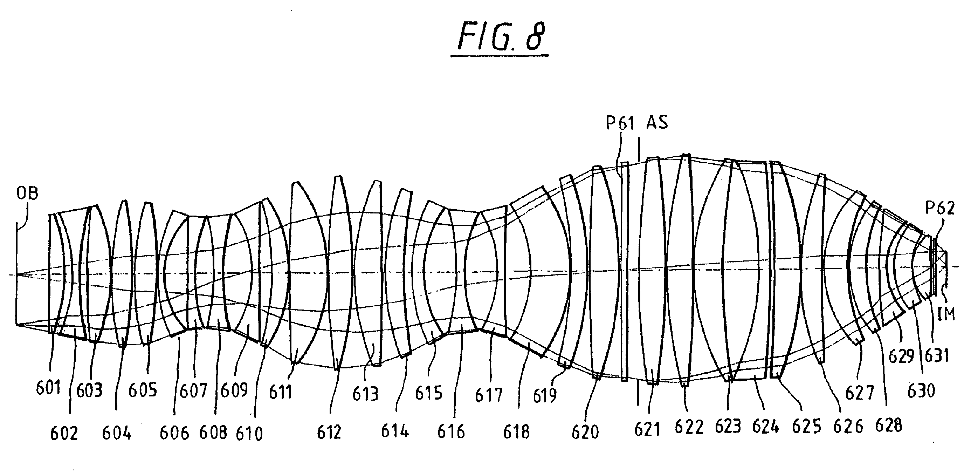

Eine weitere Linsenanordnung für die Wellenlänge 248 nm ist in Figur 8 und Tabelle 4 gezeigt.

Dieses Beispiel ist wiederum rein sphärisch aufgebaut. Es ist besonders darauf ausgelegt, daß die Verzeichnung und die weiteren Abbildungsfehler auch mit verschiedenen Beleuchtungsarten (verschiedener Kohärenzgrad. Ringaperturbeleuchtung. Quadrupolbeleuchtung) und bei deutlichem Abblenden minimal bleiben. Die Pupillenebene ist dabei auf eine Durchbiegung von 18,5 mm bei voller Apertur korrigiert.

Auch hier geschieht das dadurch, daß das gekrümmte Bild der Pupille durch gezielte Korrektur des Astigma-tismus im Tangentialschnitt weitgehend kompensiert wurde.

Die Luftlinse zwischen den Linsen 623, 624, die Aufspaltung des negativen Meniskus in zwei Linsen 624, 625 und die von der zweiten Taille (617) deutlich durch zwei positive Linsen getrennte Lage der Pupillenebene bei AS tragen zu ihrer Ebnung bei.

Bei einem hochaperturigen Projektionsabjektiv der Mikrolithographie wird demnach der Blendenfehler systematisch korrigiert, so daß eine nur wenig gekrümmte Pupillenebene das Abblenden ohne Qualitätsverlust erlaubt.

Wie schon gesagt, sind die Ausführungsbeispiele nicht beschränkend für den Gegenstand der Erfindung.

**Tabelle 1** $\lambda$(193 nm)

| No. | r (mm) | d (mm) | Glas | $H_{max}$ (mm) |
|---|---|---|---|---|
| 0 | $\infty$ | 15,691 | | 64 |
| 21 | -154,467 | 11,998 | $SiO_2$ | 64 |
| | 446.437 | 12,272 | | 73 |
| 22 | -723,377 | 25,894 | $SiO_2$ | 74 |
| | -222,214 | ,824 | | 80 |
| 23 | 920.409 | 26,326 | $SiO_2$ | 89 |
| | 287,371 | ,750 | | 90 |
| 24 | 499,378 | 30,073 | $SiO_2$ | 94 |
| | -358,998 | ,751 | | 94 |
| 25 | 238.455 | 27,454 | $SiO_2$ | 90 |
| | -3670,974 | ,750 | | 89 |
| 26 | 182,368 | 13.402 | $SiO_2$ | 81 |
| | 115,364 | 31,874 | | 72 |
| 27 | -710,373 | 13,095 | $SiO_2$ | 72 |
| | -317,933 | 2,550 | | 71 |
| 28 | -412,488 | 8,415 | $SiO_2$ | 69 |
| | 132.829 | 32,913 | | 65 |
| 29 | -184.651 | 11,023 | $SiO_2$ | 66 |
| | 2083.916 | 28,650 | | 71 |
| 30 | -120,436 | 10,736 | $SiO_2$ | 72 |
| | -629,160 | 16,486 | | 86 |
| 31 | -213.698 | 24,772 | $SiO_2$ | 89 |
| | -151,953 | ,769 | | 95 |
| 32 | 11013,497 | 48.332 | $SiO_2$ | 115 |
| | -202.880 | ,750 | | 118 |
| 33 | -1087,551 | 22,650 | $SiO_2$ | 122 |
| | -483,179 | ,750 | | 124 |
| 34 | 1797.628 | 23,724 | $SiO_2$ | 125 |
| | -1285.887 | ,751 | | 125 |
| 35 | 662,023 | 23,589 | $SiO_2$ | 124 |
| | 45816,292 | ,750 | | 123 |
| 36 | 361,131 | 22,299 | $SiO_2$ | 119 |

Tabelle fortgesetzt

| No. | r (mm) | d (mm) | Glas | $H_{max}$ (mm) |
|---|---|---|---|---|
| | 953,989 | ,750 | | 117 |
| 37 | 156.499 | 49,720 | $CaF_2$ | 107 |
| | 2938,462 | ,154 | | 103 |
| 38 | 377,619 | 8,428 | $SiO_2$ | 94 |
| | 123,293 | 40,098 | | 80 |
| 39 | -425.236 | 10.189 | $SiO_2$ | 78 |
| | 413,304 | 18,201 | | 74 |
| 40 | -302,466 | 6,943 | $SiO_2$ | 73 |
| | 190,182 | 46,542 | | 73 |
| 41 | -109,726 | 9,022 | $SiO_2$ | 73 |
| | -1968,186 | 5,547 | | 89 |
| 42 | -768,656 | 37,334 | $CaF_2$ | 90 |
| | -145,709 | ,753 | | 94 |
| 43 | 925,551 | 49,401 | $CaF_2$ | 108 |
| | -193,743 | .847 | | 109 |
| 44 | 507,720 | 22,716 | $CaF_2$ | 105 |
| | -1447,522 | 21.609 | | 104 |
| 45 | -250,873 | 11,263 | $SiO_2$ | 104 |
| | 314,449 | 2,194 | | 105 |
| 46 | 316,810 | 28,459 | $CaF_2$ | 106 |
| | -1630,246 | 4,050 | | 106 |
| AS | Blende | 15,000 | | 106 |
| 47 | 312,019 | 45,834 | $CaF_2$ | 108 |
| | -355,881 | 11,447 | | 108 |
| 48 | -242.068 | 14,119 | $SiO_2$ | 107 |
| | 312,165 | 4,687 | | 112 |
| 49 | 327,322 | 49,332 | $SiO_2$ | 114 |
| | -372,447 | 14.727 | | 115 |
| 50 | -234.201 | 26.250 | $SiO_2$ | 115 |
| | -226,616 | ,850 | | 118 |
| 51 | 203,673 | 45.914 | $SiO_2$ | 113 |
| | -3565,135 | ,751 | | 111 |
| 52 | 157,993 | 29,879 | $SiO_2$ | 94 |
| | 431,905 | 14,136 | | 90 |
| 53 | -1625,593 | 12,195 | $SiO_2$ | 88 |
| | 230.390 | ,780 | | 76 |
| 54 | 124.286 | 66,404 | $SiO_2$ | 71 |
| | 538,229 | 1,809 | | 46 |
| 55 | 778,631 | 4,962 | $CaF_2$ | 45 |
| | 43,846 | 2,050 | | 34 |
| 56 | 43,315 | 23,688 | $CaF_2$ | 33 |
| | 1056,655 | 2,047 | | 29 |
| P2 | ∞ | 2.000 | $CaF_2$ | 27 |
| | ∞ | 12,000 | | 26 |
| IM | ∞ | | | 14 |

Bildseitige numerische Apertur 0,75 Bildfelddurchmesser 29 mm

Linsen 37 davon $CaF_2$ 5

chromatischer Längsfehler CHL (500 pm) = 0,15 mm

chromatischer Querfehler CHV (500 pm) = -0,55 mm

Tabelle 2

| m736a Linsen | RADIEN | DICKEN | GLAESER | 1/2* Linsendurchmesser |
|---|---|---|---|---|
| | UNENDL | 16.6148 | | 60.752 |
| L201 | -140.92104 | 7.0000 | SIO2 | 61.267 |
| | -4944.48962 | 4.5190 | | 67.230 |
| L202 | -985.90856 | 16.4036 | SIO2 | 68.409 |
| | -191.79393 | .7500 | | 70.127 |
| L203 | 18376.81346 | 16.5880 | SIO2 | 73.993 |
| | -262.28779 | .75000 | | 74.959 |
| L204 | 417.82018 | 21.1310 | SIO2 | 77.129 |
| | -356.76055 | .7500 | | 77.193 |
| L205 | 185.38468 | 23.3034 | SIO2 | 74.782 |
| | -1198.61550 A | .7500 | | 73.634 |
| L206 | 192.13950 | 11.8744 | SIO2 | 68.213 |
| | 101.15610 | 27.6353 | | 61.022 |
| L207 | -404.17514 | 7.0000 | SIO2 | 60.533 |
| | 129.70591 | 24.1893 | | 58.732 |
| L208 | -235.98146 | 7.0584 | SIO2 | 59.144 |
| | -203.88450 | .7500 | | 60.201 |
| L209 | -241.72595 | 7.0000 | SIO2 | 60.490 |
| | 196.25453 | 33.3115 | | 65.017 |
| L210 | -122.14995 | 7.0000 | SIO2 | 66.412 |
| | -454.65265 A | 10.8840 | | 77.783 |
| L211 | -263.01247 | 22.6024 | SIO2 | 81.685 |
| | -149.71102 | 1.6818 | | 86.708 |
| L212 | -23862.31899 | 43.2680 | SIO2 | 104.023 |
| | -166.87798 | .7500 | | 106.012 |
| L213 | 340.37670 | 44.9408 | SIO2 | 115.503 |
| | -355.50943 | .7500 | | 115.398 |
| L214 | 1,60.11879 | 41.8646 | SIO2 | 102.982 |
| | 4450.50491 | .7500 | | 100.763 |
| L215 | 172.51429 | 14.8261 | SIO2 | 85.869 |
| | 116.88490 | 35.9100 | | 74.187 |
| L216 | -395.46894 | 7.0000 | SIO2 | 72.771 |
| | 178.01469 | 28.0010 | | 66.083 |
| L217 | -176.03301 | 7.0000 | SIO2 | 65.613 |
| | 188.41213 | 36.7224 | | 66.293 |
| L218 | -112.43820 | 7.0059 | SIO2 | 66.917 |
| | 683.42330 | 17.1440 | | 80.240 |
| L219 | -350.01763 | 19.1569 | SIO2 | 82.329 |
| | -194.58551 | .7514 | | 87.159 |
| L220 | -8249.50149 | 35.3656 | SIO2 | 99.995 |
| | -213.88820 | .7500 | | 103.494 |
| L221 | 657.56358 | 31.3375 | SIO2 | 114.555 |
| | -428.74102 | .0000 | | 115.245 |
| | UNENDL | 2.8420 | | 116.016 |
| | BLENDE | .0000 | | 116.016 |
| L222 | 820.30582 | 27.7457 | SIO2 | 118.196 |
| | -520.84842 | 18.4284 | | 118.605 |
| L223 | 330.19065 | 37.7586 | SIO2 | 118.273 |
| | -672.92481 | 23.8692 | | 117.550 |

Tabelle fortgesetzt

| m736a Linsen | RADIEN | DICKEN | GLAESER | 1/2* Linsendurchmesser |
|---|---|---|---|---|
| L224 | -233.67936 | 10.0000 | SiO2 | 116.625 |
| | -538.42627 | 10.4141 | | 117.109 |
| L225 | -340.26626 | 21.8583 | SIO2 | 116.879 |
| | -224.85666 | .7500 | | 117.492 |
| L226 | 146.87143 | 34.5675 | SIO2 | 100.303 |
| | 436.70958 | .7500 | | 97.643 |
| L227 | 135.52861 | 29.8244 | SIO2 | 86.066 |
| | 284.57463 | 18.9234 | | 79.427 |
| L228 | -7197.04545 | 11.8089 | SIO2 | 72.964 |
| | 268.01973 | .7500 | | 63.351 |
| L229 | 100.56453 | 27.8623 | SIO2 | 56.628 |
| | 43.02551 | 2.0994 | | 36.612 |
| L230 | 42.30652 | 30.9541 | SIO2 | 36.023 |
| | 262.65551 | 1.9528 | | 28.009 |
| | UNENDL | 12.0000 | | 27.482 |
| | UNENDL | | | 13.602 |

Asphärische Konstanten:

Koeffizienten der asphärischen Oberfläche 29:

$EX = -0,17337407 * 10^3$
$C1 = 0,15292522 * 10^{-7}$
$C2 = 0,18756271 * 10^{-11}$
$C3 = -0,40702661 * 10^{-16}$
$C4 = 0,26176919 * 10^{-19}$
$C5 = -0,36300252 * 10^{-23}$
$C6 = 0,42405765 * 10^{-27}$

Koeffizienten der asphärischen Oberfläche 27:

$EX = -0,36949881 * 10^1$
$C1 = 0,20355563 * 10^{-7}$
$C2 = -0,22884234 * 10^{-11}$
$C3 = -0,23852614 * 10^{-16}$
$C4 = -0,19091022 * 10^{-19}$
$C5 = 0,27737562 * 10^{-23}$
$C6 = -0,29709625 * 10^{-27}$

Tabelle 3

| Linsen | RADIEN | DICKEN | GLAESER | 1/2" Linsendurchmesser |
|---|---|---|---|---|
| | UNENDL | 17.8520 | | 60.958 |
| L301 | -131.57692 | 7.0000 | SiO2 | 61.490 |
| | -195.66940 | .7500 | | 64.933 |
| L302 | -254.66366 | 8.4334 | SiO2 | 65.844 |
| | -201.64480 | .7500 | | 67.386 |
| L303 | -775.65764 | 14.0058 | SiO2 | 69.629 |
| | -220.44596 | .7500 | | 70.678 |
| L304 | 569.58638 | 18.8956 . | SiO2 | 72.689 |
| | -308.25184 | .7500 | | 72.876 |
| L305 | 202.68033 | 20.7802 | SiO2 | 71.232 |

Tabelle fortgesetzt

| Linsen | RADIEN | DICKEN | GLAESER | 1/2" Linsendurchmesser |
|---|---|---|---|---|
| | -1120.20883 A | .7500 | | 70.282 |
| L306 | 203.03395 | 12.1137 | SiO2 | 65.974 |
| | 102.61512 | 26.3989 | | 59.566 |
| L307 | -372.05336 | 7.0000 | SIO2 | 59.203 |
| | 144.40889 | 23.3866 | | 58.326 |
| L308 | -207.93626 | 7.0303 | SIO2 | 58.790 |
| | -184.65938 | .7500 | | 59.985 |
| L309 | -201.97720 | 7.0000 | SIO2 | 60.229 |
| | 214.57715 | 33.1495 | | 65.721 |
| L310 | -121.80702 | 7.0411 | SIO2 | 67.235 |
| | -398.26353 A | 9.7571 | | 79.043 |
| L311 | -242:40314 | 22.4966 | SIO2 | 81.995 |
| | -146.76339 | .7553 | | 87.352 |
| L312 | -2729.19964 | 45.3237 | SIO2 | 104.995 |
| | -158.37001 | .7762 | | 107.211 |
| L313 | 356.37642 | 52.1448 | SIO2 | 118.570 |
| | -341.95165 | 1.1921 | | 118.519 |
| L314 | 159.83842 | 44.6278 | SIO2 | 105.627 |
| | 2234.73586 | .7698 | | 102.722 |
| L315 | 172.14697 | 16.8360 | SIO2 | 88.037 |
| | 119.53455 | 36.6804 | | 75.665 |
| L316 | -392.62196 | 7.0000 | SiO2 | 74.246 |
| | 171.18767 | 29.4986 | | 67.272 |
| L317 | -176.75022 | 7.0000 | SIO2 | 66.843 |
| | 186.50720 | 38.4360 | | 67.938 |
| L318 | -113.94008 | 7.0213 | SIO2 | 68.650 |
| | 893.30270 | 17.7406 | | 82.870 |
| L319 | -327.77804 | 18.9809 | SiO2 | 85.090 |
| | -192.72640 | .7513 | | 89.918 |
| L320 | -3571.89972 | 34.3608 | SIO2 | 103.882 |
| | -209.35555 | .7500 | | 106.573 |
| L321 | 676.38083 | 32.6220 | SIO2 | 119.191 |
| | -449.16650 | .0000 | | 119.960 |
| | UNENDL | 2.8420 | | 120.991 |
| | BLENDE | .0000 | | 120.991 |
| L322 | 771.53843 | 30.6490 | SiO2 | 123.568 |
| | -525.59771 | 13.4504 | | 124.005 |
| L323 | 330.53202 | 40.0766 | SiO2 | 123.477 |
| | -712.47666 | 23.6787 | | 122.707 |
| L324 | -250.00950 | 10.0000 | SiO2 | 121.877 |
| | -513.10270 | 14.8392 | | 121.995 |
| L325 | -344.63359 | 20.3738 | SiO2 | 121.081 |
| | -239.53067 | .7500 | | 121.530 |
| L326 | 146.13385 | 34.7977 | SiO2 | 102.544 |
| | 399.32557 | .7510 | | 99.992 |
| L327 | 122.97289 | 29.7786 | SiO2 | 87.699 |
| | 294.53397 | 18.8859 | | 82.024 |
| L328 | -3521.27938 | A11.4951 | SiO2 | 75.848 |
| | 287.11066 | .7814 | | 65.798 |
| L329 | 103.24804 | 27.8602 | SiO2 | 58.287 |

Tabelle fortgesetzt

| Linsen | RADIEN | DICKEN | GLAESER | 1/2" Linsendurchmesser |
|--------|--------|--------|---------|------------------------|
|        | 41.64286 | 1.9089 |         | 36.734 |
| L330   | 41.28081 | 31.0202 | SIO2   | 36.281 |
|        | 279.03201 | 1.9528 |         | 28.934 |
|        | UNENDL | 12.0000 |         | 28.382 |
|        | UNENDL |        |         | 13.603 |

## Asphärische Konstanten:

Koeffizienten der asphärischen Oberfläche 29:

$EX = -0{,}16784093 * 10^3$
$C\,1 = 0{,}49600479 * 10^{-9}$
$C\,2 = 0{,}31354487 * 10^{-11}$
$C\,3 = -0{,}65827200 * 10^{-16}$
$C\,4 = 0.44673095 * 10^{-19}$
$C\,5 = -0{,}73057048 * 10^{-23}$
$C\,6 = 0{,}91524489 * 10^{-27}$

Koeffizienten der asphärischen Oberfläche 27:

$EX = -0{,}22247325 * 10^1$
$C1 = 0{,}24479896 * 10^{-7}$
$C\,2 = -0{,}22713172 * 10^{-11}$
$C\,3 = 0{,}36324126 * 10^{-16}$
$C\,4 = -0{,}17823969 * 10^{-19}$
$C\,5 = 0{,}26799048 * 10^{-23}$
$C\,6 = -0{,}27403392 * 10^{-27}$

Koeffizienten der asphärischen Oberfläche 31:

$EX = 0$
$C\,1 = -0{,}45136584 * 10^{-09}$
$C2 = 0{,}34745936 * 10^{-12}$
$C\,3 = 0{,}11805250 * 10^{-17}$
$C\,4 = -0{,}87762405 * 10^{-21}$

**Tabelle 4**

| No. | r(mm) | d(mm) | Glas |
|-----|-------|-------|------|
| 0b  |        | 36,005 |      |
| 601 | -1823,618 | 15,518 | Quarzglas |
|     | -214,169 | 10,000 |      |
| 602 | -134,291 | 7,959 | Quarzglas |
|     | 328,009 | 6,376 |      |
| 603 | 783,388 | 26,523 | Quarzglas |
|     | -163,805 | ,600 |      |
| 604 | 335,109 | 20,797 | Quarzglas |
|     | -499,168 | 1,554 |      |
| 605 | 224,560 | 24,840 | Quarzglas |
|     | -403,777 | ,600 |      |
| 606 | 142,336 | 9,000 | Quarzglas |
|     | 86,765 | 23,991 |      |

Tabelle fortgesetzt

| No. | r(mm) | d(mm) | Glas |
|---|---|---|---|
| 607 | 6387,721 | 7,700 | Quarzglas |
| | 148,713 | 21,860 | |
| 608 | -185,678 | 8,702 | Quarzglas |
| | 237,204 | 30,008 | |
| 609 | -104,297 | 9,327 | Quarzglas |
| | -1975,424 | 12,221 | |
| 610 | -247,819 | 17,715 | Quarzglas |
| | -152,409 | ,605 | |
| 611 | 1278,476 | 40,457 | Quarzglas |
| | -163,350 | ,778 | |
| 612 | 697,475 | 28.012 | Quarzglas |
| | -346,153 | 2,152 | |
| 613 | 232,015 | 28,068 | Quarzglas |
| | -3080,194 | 2.606 | |
| 614 | 219,153 | 21,134 | Quarzglas |
| | 434,184 | 9,007 | |
| 615 | 155,091 | 13,742 | Quarzglas |
| | 103,553 | 34,406 | |
| 616 | -207,801 | 8,900 | Quarzglas |
| | 131,833 | 35,789 | |
| 617 | -118,245 | 9,299 | Quarzglas |
| | 1262,191 | 27,280 | |
| 618 | -121,674 | 42,860 | Quarzglas |
| | -151,749 | ,825 | |
| 619 | -366,282 | 20,128 | Quarzglas |
| | -236,249 | ,838 | |
| 620 | 2355,228 | 31,331 | Quarzglas |
| | -296,219 | 2,500 | |
| P61 | ∞ | 6,000 | Quarzglas |
| | ∞ | 12,554 | |
| AS | | | |
| 621 | 774,283 | 29,041 | Quarzglas |
| | -782,899 | ,671 | |
| 622 | 456,969 | 28,257 | Quarzglas |
| | -1483,609 | ,603 | |
| 623 | 227,145 | 30,951 | Quarzglas |
| | 658,547 | 36,122 | |
| 624 | -271,535 | 15,659 | Quarzglas |
| | -997,381 | 4,388 | |
| 625 | -1479,857 | 27,590 | Quarzglas |
| | -288,684 | ,604 | |
| 626 | 259,988 | 22,958 | Quarzglas |
| | 1614,379 | ,600 | |
| 627 | 105,026 | 29,360 | Quarzglas |
| | 205,658 | ,600 | |
| 628 | 110,916 | 16,573 | Quarzglas |
| | 139,712 | 13,012 | |
| 629 | 499,538 | 8,300 | Quarzglas |
| | 56,675 | 9,260 | |
| 630 | 75,908 | 17,815 | Quarzglas |

Tabelle fortgesetzt

| No. | r(mm) | d(mm) | Glas |
|---|---|---|---|
| | 51,831 | ,995 | |
| 631 | 43,727 | 19,096 | Quarzglas |
| | 499,293 | 2,954 | |
| P62 | ∞ | 2.000 | Quarzglas |
| | ∞ | 12,000 | |
| Im | | | |

## Patentansprüche

**1.** Projektionsobjektiv der Mikrolithographie, bei dem die Systemblende (AS) im Bereich der bildseitig letzten Linsengruppe (LG5 bis LG7) mit positiver Brechkraft und mit einem lokalen Maximum des Lichtbüscheldurchmessers angeordnet ist, das eine bildseitige numerische Apertur NA von über 0,65 aufweist und einen Bildfelddurchmesser von über 20mm,
**dadurch gekennzeichnet,**
**daß** mindestens zwei, vorzugsweise mindestens drei positive Linsen (42 bis 44) der bildseitig letzten Linsengruppe (LG5 bis LG7) mit positiver Brechkraft und mit einem lokalen Maximum des Lichtbündeldurchmessers objektseitig vor der Pupillenebene angeordnet sind,
und
**daß** die axiale Ablage zwischen Bildmitte und Bildrand der tangentialen Bildschale der Pupillenabbildung kleiner 20 mm, vorzugsweise kleiner 15 mm ist.

**2.** Projektionsobjektiv der Mikrolithographie, bei dem die Systemblende (AS) im Bereich der bildseitig letzten Linsengruppe (LG5 bis LG7) mit positiver Brechkraft und mit einem lokalen Maximum des Lichtbüscheldurchmessers angeordnet ist, das eine bildseitige numerische Apertur NA von über 0,65 aufweist und einen Bildfelddurchmesser von über 20mm,
**dadurch gekennzeichnet,**
**daß** mindestens zwei, vorzugsweise mindestens drei positive Linsen (42 bis 44) der bildseitig letzten Linsengruppe (LG5 bis LG7) mit positiver Brechkraft und mit einem lokalen Maximum des Lichtbündeldurchmessers objektseitig vor der Pupillenebene angeordnet sind, und
**daß** das Objektiv bei Abblendung bis auf das 0,8 fache seiner bildseitigen numerischen Apertur eine Telezentrieabweichung von unter ± 4 mrad, vorzugsweise unter ± 3 mrad, des geometrischen Schwerstrahls aufweist.

**3.** Projektionsobjektiv nach mindestens einem der Ansprüche 1 bis 2, **dadurch gekennzeichnet, daß** die erste Negativlinse (50), die bildseitig auf die Pupillenebene folgt, ein pupillenseitig konkaver Meniskus ist.

**4.** Projektionsobjektiv nach mindestens einem der Ansprüche 1 bis 3, **dadurch gekennzeichnet, daß** es aus

einer ersten Linsengruppe (LG1) mit positiver Brechkraft und mit einem lokalen Maximum des Lichtbündeldurchmessers,
einer zweiten Linsengruppe (LG2) mit negativer Brechkraft und mit einem lokalen Minimum des Lichtbündeldurchmessers,
einer dritten Linsengruppe (LG3) mit positiver Brechkraft und mit einem lokalen Maximum des Lichtbündeldurchmessers,
einer vierten Linsengruppe (LG4) mit negativer Brechkraft und mit einem lokalen Minimum des Lichtbündeldurchmessers und
einer fünften Linsengruppe (LG5 bis LG7) mit positiver Brechkraft und mit einem lokalen Maximum des Lichtbündeldurchmessers besteht.

**5.** Projektionsobjektiv nach Anspruch 4, **dadurch gekennzeichnet,**
**daß** im Bereich der fünften Linsengruppe (LG5 bis LG7) mit positiver Brechkraft und mit einem lokalen Maximum des Lichtbündeldurchmessers bildseitig nach der Pupillenebene mindestens ein sphärisch überkorrigierender Luftraum zwischen benachbarten Linsen (49, 50) angeordnet ist.

**6.** Projektionsobjektiv nach mindestens einem der Ansprüche 4 und 5, **dadurch gekennzeichnet, daß** vor der zweiten Linsengruppe (LG2) mit negativer Brechkraft und mit einem lokalen Minimum des Lichtbündeldurchmessers eine Linse (L205) mit einer asphärischen Oberfläche (29) angeordnet ist.

7. Projektionsobjektiv nach mindestens einem der Ansprüche 4 bis 6, **dadurch gekennzeichnet, daß** die vierte Linsengruppe (LG4) mit negativer Brechkraft und mit einem lokalen Minimum des Lichtbündeldurchmessers nur mit sphärischen Linsen (38 bis 41) aufgebaut ist.

8. Projektionsobjektiv nach mindestens einem der Ansprüche 1 bis 7, **dadurch gekennzeichnet, daß** Quarzglas und Fluoridkristalle, insbesondere $CaF_2$, $BaF_2$, $SrF_2$, LiF einzeln oder in Kombination als Linsenwerkstoff eingesetzt sind.

9. Projektionsbelichtungsanlase (1) der Mikrolithographie, **dadurch gekennzeichnet, daß** sie ein Projektionsobjektiv (5) nach mindestens einem der Ansprüche 1 bis 8 enthält

10. Verfahren zur Herstellung mikrostrukturierter Bauteile, bei dem ein mit einer lichtempfindlichen Schicht versehenes Substrat (15) mittels einer Maske (9) und einer Projektionsbelichtungsanlage (1) nach Anspruch 9 durch ultraviolettes Licht belichtet wird und gegebenenfalls nach Entwickeln der lichtempfindlichen Schicht entsprechend einem auf der Maske enthaltenen Muster strukturiert wird.

11. Verfahren nach Anspruch 10 mit mehreren Belichtungen mit verschiedenen Beleuchtungsarten und / oder numerischen Aperturen.

**Revendications**

1. Objectif de projection pour microlithographie, dans lequel le filtre de système (AS) est agencé dans la zone du groupe de lentilles (LG5 à LG7) qui est situé en dernier du côté de l'image et qui présente un pouvoir réfringent positif et un maximum local du diamètre du faisceau lumineux, l'objectif présentant une ouverture numérique NA supérieure à 0,65 du côté de l'image et un diamètre de champ d'image supérieur à 20 mm,
**caractérisé en ce que**
au moins deux et de préférence au moins trois lentilles positives (42 à 44) du groupe de lentilles (LG5 à LG7) situé en dernier du côté de l'image et qui présente un pouvoir réfringent positif et un maximum local du diamètre du faisceau lumineux sont agencées en amont du plan de la pupille par rapport à l'objet et **en ce que**
dans la représentation de l'image au niveau de pupille, l'écart axial entre le milieu et l'enveloppe tangentielle de l'image est inférieur à 20 mm et de préférence inférieur à 15 mm.

2. Objectif de projection pour microlithographie, dans lequel le filtre de système (AS) est agencé dans la zone du groupe de lentilles qui est situé en dernier du côté de l'image (LG5 à LG7) et qui présente un pouvoir réfringent positif et un maximal local du diamètre du faisceau lumineux, l'objectif présentant une ouverture numérique NA supérieure à 0,65 du côté de l'image et un diamètre de champ d'image supérieur à 20 mm,
**caractérisé en ce que**
au moins deux et de préférence au moins trois lentilles positives (42 à 44) du groupe de lentilles (LG5 à LG7) qui est situé en dernier du côté de l'image et qui présente un pouvoir réfringent positif et un maximum local du diamètre du faisceau lumineux sont agencées du côté de l'objet en amont par rapport au plan de la pupille et **en ce que**
lorsque l'objectif est diaphragmé jusque 0,8 fois son ouverture numérique du côté de l'image, il présente un écart de télécentrage inférieur à $\pm$ 4 mrad et de préférence inférieur à $\pm$ 3 mrad du rayon géométrique moyen pondéré.

3. Objectif de projection selon au moins l'une des revendications 1 à 2, **caractérisé en ce que** la première lentille négative (50) qui suit le plan de pupille du côté de l'image est un ménisque concave du côté de la pupille.

4. Objectif de projection selon au moins l'une des revendications 1 à 3, **caractérisé en ce qu'**il est constitué de :

un premier groupe de lentilles (LG1) qui présente un pouvoir réfringent positif et un maximum local du diamètre de faisceau lumineux,
un deuxième groupe de lentilles (LG2) qui présente un pouvoir réfringent négatif et un minimum local du diamètre du faisceau lumineux,
un troisième groupe de lentilles (LG3) qui présente un pouvoir réfringent positif et un maximum local du diamètre de faisceau lumineux,
un quatrième groupe de lentilles (LG4) qui présente un pouvoir réfringent négatif et un minimum local du diamètre du faisceau lumineux et
un cinquième groupe de lentilles (LG5 à LG7) qui présente un pouvoir réfringent positif et un maximum local du diamètre de faisceau lumineux.

5. Objectif de projection selon la revendication 4, **caractérisé en ce que** du côté de l'image, en aval du plan de pupille et dans la zone du cinquième groupe de lentilles (LG5 à LG7) qui présente un pouvoir réfringent positif et un maximum local du diamètre du rayon lumineux, au moins un espace d'air à sur-correction sphérique est agencé entre les lentilles voisines (49, 50).

6. Objectif de projection selon au moins l'une des revendications 4 et 5, **caractérisé en ce qu'**une lentille (L205) dont la surface (29) est asphérique est agencée en amont du deuxième groupe de lentilles (LG2) qui présente un pouvoir réfringent négatif et un minimum local du diamètre du faisceau lumineux.

7. Objectif de projection selon au moins l'une des revendications 4 à 6, **caractérisé en ce que** le quatrième groupe de lentilles (LG4) qui présente un pouvoir réfringent négatif et un minimum local du diamètre du faisceau lumineux n'est constitué que de lentilles sphériques (38 à 41).

8. Objectif de projection selon au moins l'une des revendications 1 à 7, **caractérisé en ce que**, comme matériaux pour les lentilles, on utilise séparément ou en combinaison du verre de quartz et des cristaux de fluorure et en particulier du $CaF_2$, du $BaF_2$, du $SrF_2$ et du LiF.

9. Installation (1) d'éclairage pour projection en microlithographie, **caractérisée en ce qu'**elle présente un objectif de projection (5) selon au moins l'une des revendications 1 à 8.

10. Procédé de fabrication de composants microstructurés, dans lequel, au moyen d'un masque (9) et d'une installation (1) d'éclairage pour projection selon la revendication 9, on éclaire à la lumière ultraviolette un support (15) doté d'une couche photosensible et, éventuellement après développement de celle-ci, on le structure selon un motif contenu sur le masque.

11. Procédé selon la revendication 10, qui présente plusieurs éclairages de types différents et/ou d'ouvertures numériques différentes.

**Claims**

1. Microlithography projection objective in the case of which the system aperture (AS) is arranged in the region of the last lens group (LG5 to LG7) on the image side of positive refractive power and with a local maximum in the light bundle diameter, and which has an image-side numerical aperture NA of over 0.65 and a field diameter of over 20 mm, **characterized in that** at least two, preferably at least three positive lenses (42 to 44) on the last lens group (LG5 to LG7) on the image side of positive refractory power and with a local maximum in the light bundle diameter are arranged on the object side upstream of the pupil plane, and **in that** the axial offset between image centre and image edge of the tangential image surface of the pupil image array is smaller than 20 mm, preferably smaller than 15 mm.

2. Microlithography projection objective in the case of which the system aperture (AS) is arranged in the region of the last lens group (LG5 to LG7) on the image side of positive refractive power and with a local maximum in the light bundle diameter, and which has an image-side numerical aperture NA of over 0.65 and a field diameter of over 20 mm, **characterized in that** at least two, preferably at least three positive lenses (42 to 44) of the last lens group (LG5 to LG7) on the image side of positive refractive power and with a local maximum in the light bundle diameter are arranged on the object side upstream of the pupil plane, and **in that**, when stopped down as far as 0.8 times its image-side numerical aperture, the objective has a telecentric deviation of below $\pm$ 4 mrad, preferably below $\pm$ 3 mrad, of the geometrical centroid beam.

3. Projection objective according to at least one of Claims 1 to 2, **characterized in that** the first negative lens (50) which follows the pupil plane on the image side is a concave meniscus on the pupil side.

4. Projection objective according to at least one of Claims 1 to 3, **characterized in that** it comprises a first lens group (LG1) of positive refractive power and with a local maximum in the light bundle diameter,

a second lens group (LG2) of negative refractive power and with a local minimum in the light bundle diameter,
a third lens group (LG3) of positive refractive power and with a local maximum in the light bundle diameter,
a fourth lens group (LG4) of negative refractive power and with a local minimum in the light bundle diameter, and
a fifth lens group (LG5 to LG7) of positive refractive power and with a local maximum in the light bundle diameter.

5. Projection objective according to Claim 4, **characterized in that** at least one spherically overcorrecting air space is arranged between neighbouring lenses (49, 50) in the region of the fifth lens group (LG5 to LG7) of positive refractive power and with a local maximum in the light bundle diameter on the image side downstream of the pupil plane.

6. Projection objective according to at least one of Claims 4 and 5, **characterized in that** a lens (L205) with an aspheric surface (29) is arranged upstream of the second lens group (LG2) of negative refractive power and with a local minimum in the light bundle diameter.

7. Projection objective according to at least one of Claims 4 to 6, **characterized in that** the fourth lens group (LG4) of negative refractive power and with a local minimum in the light bundle diameter is constructed solely with spherical lenses (38 to 41).

8. Projection objective according to at least one of Claims 1 to 7, **characterized in that** silica glass and fluoride crystals, in particular $CaF_2$, $BaF_2$, $SrF_2$, LiF are used individually or in combination as lens material.

9. Microlithography projection exposure machine (1), **characterized in that** it contains a projection objective (5) according to at least one of Claims 1 to 8.

10. Method for producing microstructured components, in which a substrate (15) provided with a photosensitive layer is exposed to ultraviolet light by means of a mask (9) and a projection exposure machine (1) according to Claim 9 and is structured in accordance with a pattern contained on the mask, if appropriate after development of the photosensitive layer.

11. Method according to Claim 10 comprising a number of exposures with different types of illumination and/or numerical apertures.

## FIG. 1

## FIG. 2

EP 1 141 781 B1

FIG.3

FIG. 4

## _FIG. 5a_

DYM ($\mu$)

TAN DW'

50

Y = -54.4
Y' = 13.6

0.1

## _FIG. 5b_

.50

Y = -51.0
Y' = 12.7

0.1

## _FIG. 5c_

.50

Y = -47.1
Y' = 11.8

0.1

## FIG.5d

DYM ($\mu$)

→ TAN DW'

.50

0.1

Y = -38.5
Y'=9.6

## FIG.5e

.50

0.1

Y= -27.2
Y= 6.8

## FIG.5f

.50

0.1

Y = -19.2
Y'= 4.8

## FIG.5g

.50

0.1

Y = .0
Y'= .0

DZS (μ)

TAN DW'

## FIG. 6a

.50

0.1

Y = -54.4
Y'= 13.6

## FIG. 6b

.50

0.1

Y = -51.0
Y'= 12.7

## FIG. 6c

.50

0.1

Y = -47.1
Y'= 11.8

DZS ($\mu$)

TAN DW'

## FIG.6d

.50

0.1

Y = -38.5
Y' = 9.6

## FIG.6e

.50

0.1

Y = -27.2
Y' = 6.8

## FIG.6f

.50

0.1

Y = -19.2
Y' = 4.8

## FIG.6g

.50

0.1

Y = .0
Y' = .0

DYS (μ)

TAN DW'

## FIG. 7a

.50

0.1

Y = -54.4
Y' = 13.6

## FIG. 7b

.50

0.1

Y = -51.0
Y' = 12.7

## FIG. 7c

.50

0.1

Y = -47.1
Y' = 11.8

## _FIG. 7d_

.50

0.1

Y = -38.5
Y' = 9.6

## _FIG. 7e_

.50

0.1

Y = -27.2
Y' = 6.8

## _FIG. 7f_

.50

0.1

Y = -19.2
Y' = 4.8

EP 1 141 781 B1

# FIG. 8

OB

P61 AS

P62

IM

601  603  605  607  609  611  613  615  617  619  627  629  631

602  604  606  608  610  612  614  616  618  620  621  622  623  624  625  626  628  630